# EUROPEAN PATENT SPECIFICATION

(11) **EP 2 037 440 B1**
(45) Date of publication and mention of the grant of the patent: **26.10.2011**
(21) Application number: 08019119.0
(22) Date of filing: 29.10.2003
(51) Int. Cl.: G09G 3/34

(54) **Dynamic self-refresh display memory**
Dynamischer sich selbst aktualisierender Anzeigespeicher
Mémoire d'affichage à actualisation automatique dynamique

(30) Priority: 24.04.2003 US 423517
(43) Date of publication of application: 18.03.2009
(62) Divisional of application: 03024960.1
(73) Proprietor: Taiwan Semiconductor Manufacturing Company, Ltd., Taiwan 300-77 (TW)
(72) Inventor: Schloeman, Dennis J., Corvallis, OR 97330 (US); Mar, Eugene J., Corvallis, OR 97330 (US)
(74) Representative: Schoppe, Fritz

(56) References cited:
- US-A- 5 612 713
- US-A- 5 677 703
- US-A1- 2002 012 159

## Description

### TECHNICAL FIELD

This invention relates to display memories and more particularly to a dynamic memory for storing data in a display having at least one MEMS device for each pixel.

### BACKGROUND

Displays and light-projectors using arrays of MEMS devices such as the micromirrors of Digital Micromirror Devices^{™} (DMD's) have been developed for a number of applications. ("Digital Micromirror Device^{™} is a trademark of Texas Instruments.) For some applications, DMD's include a static randomaccess memory (SRAM) for storing image data and addressing the array of micromirrors. Thus, the DMD SRAM's have used memory cells having a single static memory cell per pixel. Typically, each mirror in an array of mirrors is suspended above an individual SRAM cell in a corresponding array of memory cells. Address electrodes are connected to the SRAM nodes at which "1" or "0" voltages are set.

US 5,612,713 and US 5,677,703 both show MEMS devices capable of storing one bit in an SRAM cell per pixel.

Electrostatic forces applied between the address electrodes and the mirrors rotate the mirrors about an axis. The rotation is stopped at predetermined angles, limited by touching of an edge of the mirror at the substrate. Gray scale in images is accomplished by using pulse width modulation of the binary ON (1) and OFF (0) times of each mirror. Such digital operation of DMD's and other MEMS-based display arrays imposes bandwidth requirements on the display's circuitry for filling the array with data for each frame to be displayed.

Some DMD displays take advantage of mechanical latching of the mirrors and some DMD displays utilize architectures having SRAM's smaller than the micromirror array, in the sense of having a number of SRAM cells that is a fraction of the number of micromirrors in the micromirror array. In such architectures, the peak data rate can be made comparable to the average data rate. As faster and larger arrays of MEMS devices are developed for displays and other applications, further reduction of bandwidth is a very desirable goal, especially if it can be achieved in a way that does not depend on particular physical characteristics of the MEMS devices in the array.

### BRIEF DESCRIPTION OF THE DRAWINGS

The features and advantages of the invention will be readily appreciated by persons skilled in the art from the following detailed description when read in conjunction with the drawings, wherein:
FIG. 1 is a schematic diagram of an embodiment of a memory cell made in accordance with the invention.
FIG. 2 is a timing diagram of the memory cell embodiment shown in FIG. 1.

### DETAILED DESCRIPTION OF EMBODIMENTS

For clarity, the following detailed description focuses on a particular simple embodiment of a dynamic self-refreshing memory cell for a MEMS device of an array of MEMS devices. Those skilled in the art will recognize that the invention may be readily implemented in other similar embodiments. For specificity, the MEMS device with which the invention is used may be considered to be a digital micromirror device (DMD), but the invention may be applied to any kind of MEMS device and to an array of any kind of MEMS devices.

Throughout this specification and the appended claims, the term "MEMS" has its conventional meaning of a micro-electro-mechanical system. Where particular devices are designated as "P-channel" or "N-channel," etc. for specificity of the description of a particular example embodiment, those skilled in the art will recognize that bipolar devices or other combinations of device types may be used with appropriate signals.

Embodiments made in accordance with the present invention have a dynamic memory cell for storing data in a display having at least one MEMS device for each pixel. The dynamic memory cell has at least two dynamic memory elements per pixel, including first and second dynamic memory elements, each including at least one capacitor for storing charge. Both of the first and second memory elements are electrically coupled to the MEMS device of a single pixel. A sense amplifier is configured to amplify the data signal and to latch data in response to a differential data signal and a clock signal, self-refreshing the data and loading data to the MEMS device as required. The same sense amplifier may be used to read the data stored (e.g., for testing), as is discussed in more detail hereinbelow.

Other embodiments made in accordance with the present invention have a number N of dynamic memory elements per pixel, where N is greater than two. Embodiments with exactly two dynamic memory elements per pixel reduce the data bandwidth by a factor of two. Those skilled in the art will recognize that, similarly, embodiments with N dynamic memory elements per pixel can reduce the data bandwidth by about a factor of 2^{(N-1)}. It is convenient for many such applications to make N an even number. Of course, larger values of the number N require larger numbers of transistors or other active devices, and there are costs associated with the additional active devices, including fabrication costs, yield-related costs, and reliability-related costs. Thus, in practical applications there are tradeoffs among bandwidth reduction, device fabrication costs, and various other cost factors which are familiar to those skilled in the art.

The memory for a display device has a number of memory cells, at least one memory cell for each pixel of the display. The memory cell or an entire array of memory cells may be incorporated into an integrated circuit, may be incorporated on a substrate carrying microelectronics, and may be incorporated into an electronic device.

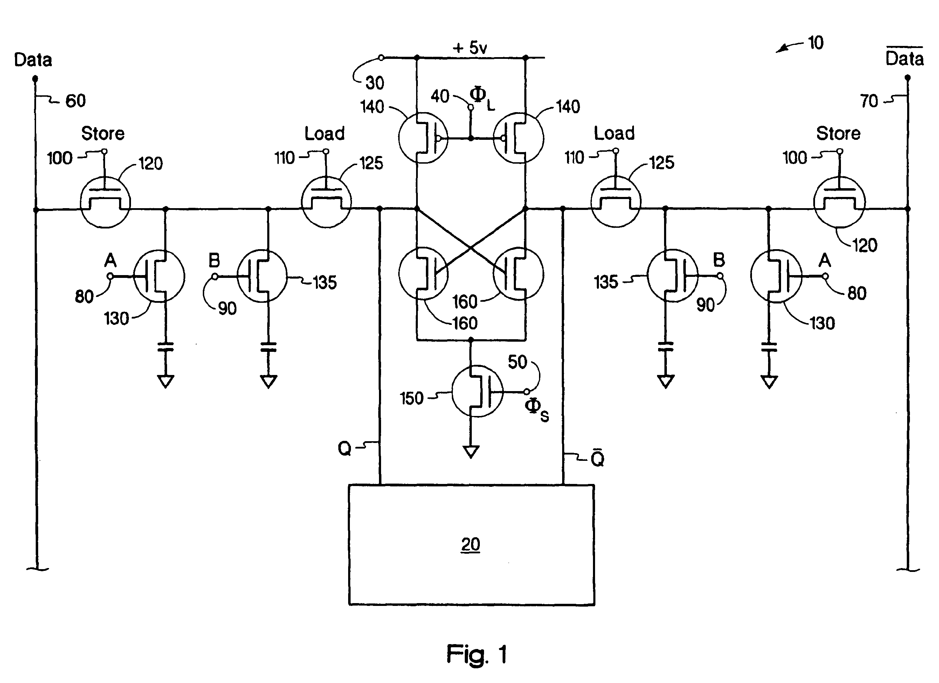

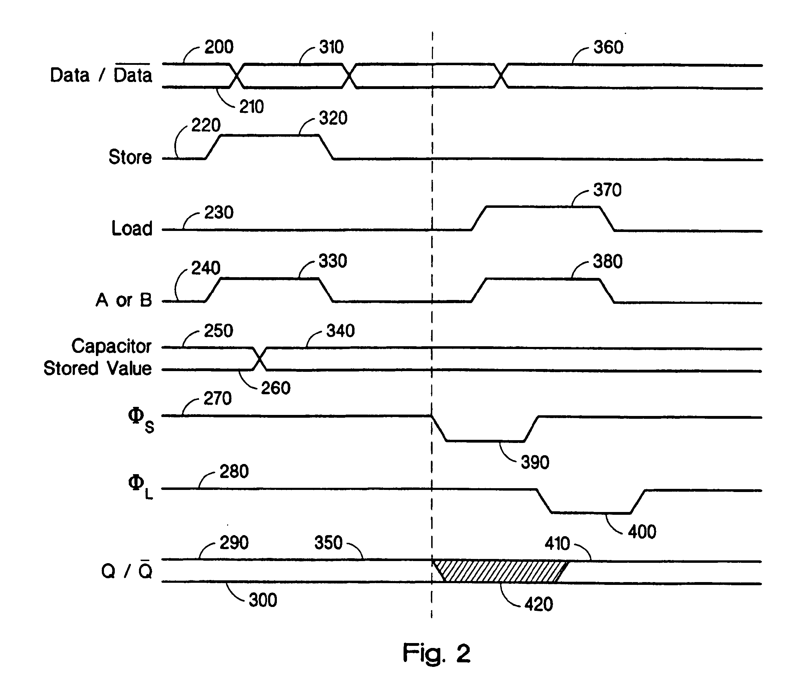

FIG. 1 shows a schematic diagram of a simple embodiment of a memory cell 10 made in accordance with the invention. A representative timing diagram of the memory cell embodiment of FIG. 1 is shown in FIG. 2. The schematic diagram shows a two-memory-element dynamic memory cell with thirteen transistors and four capacitors driving a MEMS device **20** for a single pixel of a display or of an array of other MEMS devices.

Memory cell **10** may be used in a display of the type having at least one MEMS device **20** corresponding to each pixel. It will be understood that MEMS device **20** may be more complex than a simple micromirror and may, in fact, comprise more than one MEMS device, but for purposes of understanding the embodiment illustrated in FIGS. 1 and 2, MEMS device **20** may be considered to be a simple MEMS micromirror.

Memory cell **10** is used for storing data in response to a data signal provided as a differential signal including true and complementary data lines (true signal **60** and its complementary signal 70) and a clock signal **50** (Φ_{S}). This particular embodiment has exactly two dynamic memory elements per pixel. Each of the two dynamic memory elements has a capacitor for charge storage. (In FIG. 1, the capacitors are designated as **A** or **B** capacitors, corresponding to the designation at the gates **80** or **90** of their associated transistors **130**.) Both of the two dynamic memory elements are electrically coupled to the MEMS device **20** of a single pixel, as shown in FIG. 1. A sense amplifier (defined by devices **140**, **150**, and **160** as described hereinbelow) is configured to amplify the data signal and to latch data in response to the data signals **60** and **70** as timed by clock signal **50**. For illustrative purposes, VDD power supply line **30** is shown in FIG. 1 as supplying +5V; that supply voltage is chosen to be suitable for the application and for the active device types used.

One of the problems with implementing a dynamic memory approach is refreshing the charge- storage capacitors in the memory cells. The same sense amplifier for each pixel is used to refresh the local charge-storage elements. Thus, the dynamic memory cell **10** of FIG. 1 is a self-refreshing memory cell.

Reading of the stored data does not have to be fast, since reading is required for test purposes only. For read operations, the sense amplifier is also used to drive the read data on the bit lines.

In the sense amplifier, P-channel device **140** is enabled when Φ_{L} is asserted low. Device **140** allows signals **Q** and /**Q** (shown in the drawings with an overbar) to be attached to VDD through high impedance loads in order to amplify the **Q** and /**Q** signal value. Amplification can occur only after one of two storage capacitors is enabled by either device **130** or **135** and devices **125** and **150** are also enabled. N-channel device **150** is enabled when Φ_{S} is asserted high. Device **150** allows a signal path to ground for cross-coupled devices **160** so that **Q** and /**Q** can be amplified when device **140** is enabled. N-channel devices **160** form the cross-coupled devices of the sense amplifier. Devices **160** are used for positive feedback of signals on Q and /**Q** so that those signals can be amplified when device **150** is enabled first and then device **140** is enabled second.

The dynamic memory cell with two memory elements per pixel requires at least two capacitors and requires fewer transistors than an SRAM memory cell would require. (A static SRAM approach with two memory elements per pixel would require about twenty transistors.) The dynamic memory cell has one sense amplifier per pixel to latch the appropriate input data and to amplify the data signal to an amplitude voltage suitable for actuating the MEMS device. If the MEMS device is a micromirror, for example, the voltage level from the sense amplifier is suitable for actuating a micro-mirror device. For simplicity, it is assumed in this description that the MEMS device holds a binary value loaded into it for at least a suitable predetermined time after the value is loaded.

The following description will be more readily understood by reference to the timing diagram in FIG. 2 in conjunction with the schematic diagram of FIG. 1.

In FIG. 1, the charge-storage capacitors are identified as **A** or **B** capacitors by the reference letter **A** or **B** shown at the gate of each corresponding FET device **130** or **135** respectively. The bit line of the memory consists of a conventional complementary signal pair, DATA and its complement /DATA (shown in the drawings with an overbar), represented by vertical lines **60** and **70** in FIG. 1. As indicated at the lower ends of the DATA and /DATA lines in FIG. 1, these may extend to other memory cells of an array. Other elements in FIG. 1 are described in more detail below.

In the timing diagram, FIG. 2, the vertical dashed line divides the time to distinguish the STORE portion (left) from the LOAD portion (right). FIG. 2 shows the DATA and /DATA signals (**200** and **210** respectively) and their values **310** and **360** at different times, the STORE signal **220** and its value **320** when asserted, the LOAD signal **230** and its value **370** when asserted, the **A** or **B** selection signal **240** and its values **330** for a STORE operation and **380** for a LOAD operation, the capacitor stored values **250** and **260** with representative value **340**, STORE clock signal Φ_{S} (270) and its value **390** at a certain time, and LOAD clock signal Φ_{L}(**280**) and its value **400** at a later time. FIG. 2 also shows the MEMS-device value **Q** (**290**) and its value **350** at a particular time before loading a new value into the MEMS device **20**, and FIG. 2 shows its complement /**Q** (**300**) and the value **410** of /Q at another time after loading the new value into the MEMS device **20**. Reference numeral **420** denotes a transition time interval during which the values of **Q** and /**Q** are indeterminate.

N-channel FET devices **120** are enabled when the STORE signal is asserted high. Devices **120** allow storage of the value of DATA and its complement /DATA when either the **A** or **B** capacitor select signal is asserted high. Storing a pixel value is done by asserting the STORE signal **220** at a high value and by also selecting **330** either the A or B storage capacitors with gates **80** or **90** (line **240** in FIG. 2). The bit line is driven differentially with DATA **200** and complementary /DATA **210** values, and the corresponding data value is stored into one of selected capacitors (**A** or **B**) on either side. Devices **120** also allow reading of stored charge on a selected one of the two capacitor storage cells after the stored charge is loaded into the sense amplifier. Reading is then done by enabling device **125** and either device **130** or **135**, and then enabling device **120** after the sense amplifier has amplified the storage-node charge signal. N-channel FET devices **125** are enabled when LOAD signal **230** (terminals **110** in FIG. 1) is asserted high.

N-channel FET device **130** is enabled when signal A is asserted high. Device **130** allows signals on DATA and /DATA to be stored on the respective capacitors when device **120** is also enabled at the same time. Device **130** also allows the storage capacitor value to be amplified and refreshed when devices **125** and **130** are enabled.

N-channel FET device **135** is enabled when signal B is asserted high. Device **135** allows signals on DATA and /DATA to be stored on the respective capacitors when device **120** is also enabled at the same time. Device **135** also allows storage capacitor value to be amplified and refreshed by the sense amplifier when devices **125** and **135** are enabled.

Loading the stored memory elements in the MEMS latch is done by first de-asserting the two sense-amplifier clock signals **270** (Φ_{S}) and 280 (Φ_{L}), asserting the LOAD signal **230** at a high value, and selecting one of two stored values: **A** or **B** (**330**).

N-channel FET devices **125** allow charged signal in one of two storage capacitors to be amplified by the sense amplifier when either **A** or **B** signal is asserted high and LOAD signal **230** (terminals **110** in FIG. 1) is asserted high.

FET devices **125** also allow reading of stored charge on one of two capacitor storage cells. Reading is done by enabling device **125** and either device **130** or **135** to select the **A** or **B** capacitor, and by then also enabling device **120** after the sense amplifier has amplified the storage node charge signal.

Once the cross-couple sense-amplifier has had sufficient time to differentiate the signal, the clock signal **50** (Φ_{S}) for the N-channel devices **160** is asserted at a high value to resolve the differential input signal. At a later time, both P-channel devices **140** are turned on, which pulls the high input side to VDD. To reduce power dissipation, the P-channel devices **140** are turned off once the required voltage is attained. The LOAD signal remains asserted (**370** in FIG. 2) until after the P-channel devices **140** are turned on. This allows the sense amplifier to refresh the selected **A** or **B** memory capacitor.

The same sense amplifier is also used to drive the data on the bit lines for read operations. Reading the stored pixel value requires the selection of one of two pixel values to be loaded into the sense amplifier and latched. Once the value is latched, the STORE line **220** is asserted high (**320** in FIG. 2) to allow the data to be driven on the bit lines. The end of the bit line has another sense amplifier (not shown) to sense the data and to provide sufficient gain to latch the read data quickly.

Thus, in the embodiment of FIGS. 1 and 2, the first dynamic memory element includes a first storage capacitor **A**, the second dynamic memory element includes a second storage capacitor **B**, and data is stored selectively in a selected storage capacitor **A** or B in accordance with a capacitor selection signal. The sense amplifier refreshes data stored in the selected capacitor in accordance with the capacitor selection signal. Similarly, data is loaded to the MEMS device selectively from a selected one of the storage capacitors **A** or **B** in accordance with the capacitor selection signal. Thus, the sense amplifier is adapted to read data stored in a selected one of the storage capacitors **A** or **B** in accordance with a read signal. As described above, the read signal is sent by enabling device **125** and either device **130** or **135** to select the **A** or **B** capacitor, and by then also enabling device **120** after the sense amplifier has amplified the storage node charge signal.

### FABRICATION

A display using the present invention and having a desired number of pixels arranged in an array may be made by providing a substrate and forming an array of MEMS devices on the substrate, at least one MEMS device corresponding to each pixel. Each MEMS device of the array is configured to be actuated by an electrical signal on at least one actuation electrode. The fabrication also includes forming on the substrate a dynamic memory cell for each pixel, each dynamic memory cell including first and second dynamic memory elements, each including at least one capacitor, both of the first and second memory elements being electrically coupled to the actuation electrode of the MEMS device corresponding to a single pixel. Each dynamic memory cell that is formed also includes a sense amplifier configured to amplify the data signal and to latch data in response to a data signal and a clock signal.

Forming the MEMS devices is accomplished using conventional MEMS processes well known to those skilled in the art, selecting those unit processes that are compatible with semiconductor processing of the dynamic memory elements. An example of such MEMS processes is the fabrication on the substrate of an array of digital micro-mirror devices, one or more digital micro-mirror devices corresponding to each pixel. The dynamic memory elements are formed by conventional semiconductor fabrication processes, such as conventional CMOS processes. Again, unit processes are chosen to be compatible with MEMS processing.

### INDUSTRIAL APPLICABILITY

Dynamic self-refreshing memory cells made in accordance with the present invention may be used for a variety of MEMS arrays, including arrays of digital micromirror display devices. Having more than one memory element per pixel reduces data bandwidth required for the MEMS devices, and the dynamic approach requires fewer transistors and thus smaller area than an equivalent two-memory conventional static approach. A local sense amplifier for each pixel allows refreshing of the selected pixel value and also allows driving the bit lines in read operations.

In accordance with a useful aspect of the invention, a method is provided for using a dynamic memory cell in a display of the type having at least one MEMS device corresponding to each pixel: a dynamic memory cell is provided for each pixel, each dynamic memory cell including first and second dynamic memory elements, each of the first and second dynamic memory elements including at least one capacitor. Both of the first and second memory elements are electrically coupled to the MEMS device corresponding to a single pixel.

A differential data signal, a clock signal, and a capacitor selection signal are provided to each dynamic memory cell. In response to the differential data signal, the capacitor selection signal, and a first phase of the clock signal, data is stored in at least one capacitor of a selected one of the dynamic memory elements. Data is stored in at least one capacitor, refreshed, and amplified.

In response to the capacitor selection signal and a second phase of the clock signal, selected data is loaded to the MEMS device corresponding to each pixel to display information in accordance with the differential data signal. If desired, this method can also include reading the data stored. This method can reduce the bandwidth required for a memory cell having one memory element per pixel by about half if just two memory elements are used per pixel. If a number N of memory elements per pixel larger than two is used, the bandwidth requirement can be further reduced.

Although the foregoing has been a description and illustration of specific embodiments of the invention, various modifications and changes thereto can be made by persons skilled in the art without departing from the scope and spirit of the invention as defined by the following claims. For example, various MEMS devices, including both display devices and other (non-display) MEMS devices may be used with memory cells made in accordance with the invention, either individually or arranged in arrays, and other MOS or bipolar transistors or other active devices may be used in place of the CMOS devices used in the illustrated embodiments.

## Claims

1. A memory cell (10) for a display of the type having at least one MEMS device (20) corresponding to each pixel, the memory cell (10) storing data in response to a differential data signal and a clock signal, **characterised in that** the memory cell (10) comprises:
first and second dynamic memory elements, both of the first and second memory elements being electrically coupled to a MEMS device (20) corresponding to a single pixel, the first dynamic memory element including a first storage capacitor and the second dynamic memory element including a second storage capacitor, data being stored selectively in a selected one of the first and second storage capacitors in accordance with a capacitor selection signal at a first phase of the clock signal, and data being loaded to the MEMS device (20) selectively from a selected one of the first and second storage capacitors in accordance with a capacitor selection signal at a second phase of the clock signal; and
a sense amplifier configured to amplify the differential data signal to a predetermined level suitable for actuating the at least one MEMS device (20) and to latch data in response to the differential data signal and the clock signal, thereby refreshing the data in the selected storage capacitor.

2. A method of using a dynamic memory cell (10) in a display of the type having at least one MEMS device (20) corresponding to each pixel, **characterised in that** the method comprises steps of:
a) providing a dynamic memory cell (10) for each pixel, each dynamic memory cell (10) having at least two dynamic memory elements per pixel, including first and second dynamic memory elements, each of the first and second dynamic memory elements including at least one capacitor;
b) selectively electrically coupling one of the first and second memory elements to the at least one MEMS device (20) corresponding to a single pixel;
c) providing a differential data signal, a clock signal, and a capacitor selection signal to each dynamic memory cell (10);
d) in response to the differential data signal, the capacitor selection signal, and a first phase of the clock signal, storing data in at least one capacitor of a selected one of the first and second dynamic memory elements;
e) refreshing and amplifying data stored in the at least one capacitor in response to the capacitor selection signal and a second phase of the clock signal, thereby loading selected data to the at least one MEMS device (10) corresponding to each pixel to display information in accordance with the differential data signal.

3. The method of claim 2, further comprising the step of: f) reading data stored in data-storing step d).

## Patentansprüche

1. Eine Speicherzelle (10) für eine Anzeige des Typs, der zumindest ein MEMS-Bauelement (20) aufweist, das jedem Pixel entspricht, wobei die Speicherzelle (10) ansprechend auf ein Differenzdatensignal und ein Taktsignal Daten speichert, **dadurch gekennzeichnet, dass** die Speicherzelle (10) folgende Merkmale aufweist:
ein erstes und ein zweites dynamisches Speicherelement, wobei sowohl das erste als auch das zweite Speicherelement mit einem einem einzelnen Pixel entsprechenden MEMS-Bauelement (20) elektrisch gekoppelt sind, wobei das erste dynamische Speicherelement einen ersten Speicherkondensator umfasst und das zweite dynamische Speicherelement einen zweiten Speicherkondensator umfasst, wobei Daten in einem ausgewählten des ersten und des zweiten Speicherkondensators gemäß einem Kondensatorauswahlsignal bei einer ersten Phase des Taktsignals selektiv gespeichert werden und Daten aus einem ausgewählten des ersten und des zweiten Speicherkondensators gemäß einem Kondensatorauswahlsignal bei einer zweiten Phase des Taktsignals selektiv in das MEMS-Bauelement (20) geladen werden; und
einen Leseverstärker, der dazu konfiguriert ist, das Differenzdatensignal auf einen vorbestimmten Pegel zu verstärken, der dazu geeignet ist, das zumindest eine MEMS-Bauelement (20) zu betätigen und ansprechend auf das Differenzdatensignal und das Taktsignal Daten zwischenzuspeichern, wodurch die Daten in dem ausgewählten Speicherkondensator aufgefrischt werden.

2. Ein Verfahren zum Verwenden einer dynamischen Speicherzelle (10) in einer Anzeige des Typs, der zumindest ein MEMS-Bauelement (20) aufweist, das jedem Pixel entspricht, **dadurch gekennzeichnet, dass** das Verfahren folgende Schritte aufweist:
a) Bereitstellen einer dynamischen Speicherzelle (10) für jedes Pixel, wobei jede dynamische Speicherzelle (10) zumindest zwei dynamische Speicherelemente pro Pixel aufweist, einschließlich eines ersten und eines zweiten dynamischen Speicherelements, wobei sowohl das erste als auch das zweite dynamische Speicherelement jeweils zumindest einen Kondensator umfassen;
b) selektives elektrisches Koppeln eines des ersten und des zweiten Speicherelements mit dem zumindest einen MEMS-Bauelement (20), das einem einzelnen Pixel entspricht;
c) Liefern eines Differenzdatensignals, eines Taktsignals und eines Kondensatorauswahlsignals an jede dynamische Speicherzelle (10);
d) ansprechend auf das Differenzdatensignal, das Kondensatorauswahlsignal und eine erste Phase des Taktsignals, Speichern von Daten in zumindest einem Kondensator eines ausgewählten des ersten und des zweiten dynamischen Speicherelements;
e) Auffrischen und Verstärken von in dem zumindest einen Kondensator gespeicherten Daten ansprechend auf das Kondensatorauswahlsignal und eine zweite Phase des Taktsignals, und **dadurch** Laden ausgewählter Daten in das zumindest eine MEMS-Bauelement (10), das jedem Pixel entspricht, um Informationen gemäß dem Differenzdatensignal anzuzeigen.

3. Das Verfahren gemäß Anspruch 2, das ferner folgenden Schritt aufweist: f) Lesen von bei dem Datenspeicherschritt d) gespeicherten Daten.

## Revendications

1. Cellule de mémoire (10) pour un moyen d'affichage du type présentant au moins un dispositif MEMS (20) correspondant à chaque pixel, la cellule de mémoire (10) mémorisant des données en réponse à un signal de données différentiel et un signal d'horloge, **caractérisée par le fait que** la cellule de mémoire (10) comprend:
un premier et un deuxième élément de mémoire dynamique, l'un et l'autre parmi les premier et deuxième éléments de mémoire étant couplés électriquement à un dispositif MEMS correspondant à un seul pixel, le premier élément de mémoire dynamique comportant un premier condensateur de mémoire et le deuxième élément de mémoire dynamique comportant un deuxième condensateur de mémoire, les données étant mémorisées de manière sélective dans l'un sélectionné parmi les premier et deuxième condensateurs de mémoire selon un signal de sélection de condensateur à une première phase du signal d'horloge, et les données étant chargées dans le dispositif MEMS (20) de manière sélective à partir de l'un sélectionné parmi les premier et deuxième condensateurs de mémoire selon un signal de sélection de condensateur à une deuxième phase du signal d'horloge; et
un amplificateur de détection configuré pour amplifier le signal de données différentiel à un niveau prédéterminé convenant pour actionner l'au moins un dispositif MEMS (20) et pour verrouiller les données en réponse au signal de données différentiel et au signal d'horloge, rafraîchissant ainsi les données dans le condensateur de mémoire sélectionné.

2. Procédé d'utilisation d'une cellule de mémoire dynamique (10) dans un moyen d'affichage du type présentant au moins un dispositif MEMS (20) correspondant à chaque pixel, **caractérisé par le fait que** le procédé comprend les étapes consistant à:
a) prévoir une cellule de mémoire dynamique (10) pour chaque pixel, chaque cellule de mémoire dynamique (10) présentant au moins deux éléments de mémoire dynamiques par pixel, comportant un premier et un deuxième élément de mémoire dynamique, chacun des premier et deuxième éléments de mémoire dynamiques comportant au moins un condensateur;
b) coupler électriquement de manière sélective l'un parmi les premier et deuxième éléments de mémoire à l'au moins un dispositif MEMS (20) correspondant à un seul pixel;
c) fournir un signal de données différentiel, un signal d'horloge et un signal de sélection de condensateur à chaque cellule de mémoire dynamique (10);
d) en réponse au signal de données différentiel, au signal de sélection de condensateur et à une première phase du signal d'horloge, mémoriser les données dans au moins un condensateur de l'un sélectionné parmi les premier et deuxième éléments de mémoire dynamiques ;
e) rafraîchir et amplifier les données mémorisées dans l'au moins un condensateur en réponse au signal de sélection de condensateur et une deuxième phase du signal d'horloge, chargeant ainsi les données sélectionnées dans l'au moins un dispositif MEMS (10) correspondant à chaque pixel, pour afficher les informations selon le signal de données différentiel.

3. Procédé selon la revendication 2, comprenant par ailleurs l'étape consistant à: (f) lire les données mémorisées à l'étape de mémorisation de données d).
